# EUROPÄISCHE PATENTANMELDUNG

(11) **EP 1 271 638 A2**
(43) Veröffentlichungstag der Anmeldung: **02.01.2003**
(21) Anmeldenummer: 02012666.0
(22) Anmeldetag: 07.06.2002
(51) Int. Cl.: H01L 21/336

(54) **Verfahren zur Herstellung eines DMOS-Transistors**

(30) Priorität: 29.06.2001 DE 10131705
(71) Anmelder: ATMEL Germany GmbH, 74072 Heilbronn (DE)
(72) Erfinder: Bromberger, Christoph, 74211 Leingarten (DE); Dietz, Franz, 74081 Heilbronn (DE); Dudek, Volker, Dr., 74336 Brackenheim (DE); Graf, Michael, Dr., 71229 Leonberg (DE); Herrfurth, Jörn, 74080 Heilbronn (DE); Klaussner, Manfred, 74080 Heilbronn (DE)
(74) Vertreter: Kolb, Georg

(57) **Zusammenfassung**

Bei den bisher bekannten Verfahren zur Herstellung eines DMOS-Transistors (100) ist bei einer grabenförmigen Struktur die Dotierung der Seitenwände an die Dotierung des Bodenbereiches gekoppelt. Nach dem vorliegenden Verfahren läßt sich bei einer grabenförmigen Struktur die Dotierung der Seitenwände (40,60) unabhängig von der Dotierung des Bodenbereiches (50) einstellen. Ferner läßt sich auch die Dotierung zwischen den Seitenwänden unterschiedlich einstellen. Damit lassen sich bei den DMOS Transistoren bei niedrigen Einschaltwiderständen hohe Durchbruchspannungen erzeugen und den Flächenverbrauch insbesondere von Treiberstrukturen verringern.

## Beschreibung

Die vorliegende Erfindung betrifft ein Verfahren zur Herstellung eines DMOS Transistors, gemäß dem Oberbegriff des Patentanspruchs 1.

Ein derartiges Verfahren ist aus der Druckschrift US 5 539 238 bekannt. Hierbei wird ein DMOS Transistor mit einer tiefen Trenchstruktur erzeugt, wobei die dotierten Bereiche die sich an die Seitenwände und an den Boden-Bereich anschließen, die sogenannte Driftzone des Transistors darstellen. Durch die teilweise vertikale Ausbildung der Driftzone entlang der Seitenwände des Trenches, lässt sich die Länge des Transistors verringern. Nachteilig an dem Verfahren ist, daß bei einer anliegenden Sperrspannung an den Kanten der Trenchstruktur Inhomogenitäten in dem Potentialverlauf auftreten, die zu einer unerwünschten Erniedrigung der Sperrspannung des Transistors führen. Ferner wird die Gesamtlänge der Driftregion nicht erniedrigt, sondern nur in einen vertikalen und einen lateralen Anteil aufgeteilt, d.h. der spezifische Einschaltwiderstand Rsp = Rdson/ Fläche wird nicht erniedrigt, vielmehr lassen sich die Seitenwände nur unzureichend dotieren und der spezifische Einschaltwiderstand Rsp und damit der Flächenverbrauch des Transistors werden erhöht.

Ein weiteres Verfahren ist aus der Druckschrift EP 0 837 509 A1 bekannt. Hierbei wird in einem DMOS Transistor unterhalb einem LOCOS-Oxides ein selbstjustiertes Driftgebiet erzeugt. Nachteilig ist, daß die Dotierung des Driftgebietes vor der Oxidation eingebracht wird und sich der Anteil des Dotierstoffes, der bei der Oxidation in das Oxid eindiffundiert nur ungenau bestimmen läßt. Ferner bewirkt die hohe Temperaturbelastung bei der Oxidation eine sehr breite Dotierstoffverteilung, die ihrerseits eine größere Ungenauigkeit in der Dotierstoffkonzentration verursacht. Des Weiteren ist unterhalb des Oxides eine große Siliziumdicke erforderlich, um mittels des sogenannten "RESURF" Effekts die Sperrspannung zu erhöhen. Insgesamt werden durch die Prozessstreuungen die Streuungen in den elektrischen Parametern des Transistors vergrößert.

Ein Ziel in der Entwicklung auf dem Gebiet der DMOS Transistoren ist es, platzsparende Strukturen herzustellen, die bei einer anliegenden Sperrspannung niedrige Feldstärken aufweisen, um eine Generation von Ladungsträgern, die zu einem Durchbruch innerhalb des Bauelementes führen, zu vermeiden. Ein weiteres Ziel der Entwicklung bei den DMOS Transistoren ist es, einen niedrigen spezifischen Einschaltwiderstand Rsp zu erzielen, um bei integrierten Schaltungen bei denen die DMOS Transistoren einen wesentlichen Anteil an der Gesamtchipfläche beanspruchen, den Flächenverbrauch einer derartigen integrierten Schaltung zu reduzieren. Der vorliegenden Erfindung liegt daher die Aufgabe zu Grunde, ein Verfahren anzugeben, mit dem sich DMOS Transistoren auf kleiner Fläche für hohe Sperrspannungen herstellen lassen.

Die erstgenannte Aufgabe wird durch die Merkmale des Patentanspruches 1 gelöst. Günstige Ausgestaltungsformen sind Gegenstand von Unteransprüchen.

Hiernach besteht das Wesen der Erfindung darin, daß in einem DMOS Transistor eine grabenförmigen Struktur erzeugt wird, bei der durch Wahl des Dotierstoffprofils im Bereich der grabenförmigen Struktur eine hohe Durchbruchspannung bei einer geringen lateralen Ausdehnung des DMOS Transistors erreicht werden. Hierzu wird in einem Halbleiterkörper einres ersten Leitfähigkeitstyps, der eine Oberflächenschicht aufweist, in der ein Source Bereich und ein Drain Bereich eines zweiten Leitfähigkeitstyps, und einen erster Wannen Bereich eines ersten Leitfähigkeitstyps, der den Source Bereich einschließt, und einen zweiten Wannen Bereich eines zweiten Leitfähigkeitstyps, der den Drain Bereich einschließt, ausgebildet ist, und auf der Oberfläche des Halbleiterkörpers ein Gate Bereich ausgebildet ist, der sich beginnend von dem Source Bereich vollständig über den Wannen Bereich des ersten Leitfähigkeitstyps erstreckt, beginnend von der Oberfläche des Halbleiterkörpers in einem Teil der Oberflächenschicht eine grabenförmige Struktur erzeugt. Ferner wird im Bodenbereich der grabenförmigen Struktur eine Dotierung eines zweiten Leitfähigkeitstyps mit einer ersten Konzentration und in der sourceseitigen Seitenwand der grabenförmigen Struktur eine Dotierung des zweiten Leitfähigkeitstyps mit einer zweiten Konzentration und in der drainseitigen Seitenwand, der grabenförmigen Struktur eine Dotierung des zweiten Leitfähigkeitstyps mit einer dritten Konzentration erzeugt.

Ein wesentlicher Vorteil des neuen Verfahrens ist es, daß sich durch die unterschiedliche Konzentration des Dotierstoffes in der sourceseitigen Seitenwand gegenüber der drainseitigen Seitenwand in Verbindung mit der Dotierstoffkonzentration in dem Bodenbereich der grabenförmigen Struktur, die zusammen den Driftbereich des Transistors definieren, eine einfache Optimierung innerhalb eines Parameterfeldes, das im Wesentlichen von dem spezifischen Einschaltwiderstand Rsp, der Durchbruchspannung Vbreak und der Größe und Form der SOA (safe-operation-area) Fläche bestimmt wird, durchführen läßt. Insbesondere für Treiberstrukturen lassen sich damit Transistoren mit einer geringen Gesamtfläche erzeugen. Ferner läßt sich mittels einer unterschiedlich hohen Dotierstoffkonzentration entlang der grabenförmigen Struktur, das Einsetzen und die Stärke des RESURF Effekts mittels einer einstellbaren vertikalen Ableitung des Potentialgradienten der anliegenden Sperrspannung besonders vorteilhaft optimieren. Da die Dotierung erst nach der Siliziumätzung mit einer niedrigen Implantationsenergie erfolgt und anschließend kein dickes LOCOS-Oxid mit einer hohen Temperaturbelastung erzeugt wird, lassen sich unterhalb des Bodens der grabenförmigen Struktur auf einer geringen vertikalen Strecke räumlich hochdotierte Bereiche erzeugen, die einen vergrabenen Strompfad mit einem geringem Widerstand ausbilden. Da die Dotierung des Bodens mittels des RESURF Effekts in Verbindung mit dem Dotierungsverlauf in der sourceseitigen Seitenwand einen wesentlichen Einfluß auf die Durchbruchspannung im sperrenden als auch im eingeschalteten Zustand hat, während der drainseitige Dotierstoffverlauf wesentlichen Einfluß auf den Einschaltwiderstand Rdson hat, ist eine Anpassung der Dotierprofile entlang der grabenförmigen Struktur an die elektrischen Anforderungen besonders vorteilhaft. Des Weiteren wird der Flächenverbrauch der Transistoren verringert, da sich durch die Selbstjustierung in Verbindung mit einer gleichzeitig reduzierten Temperaturbelastung gegenüber einer LOCOS-Oxidation die Prozeßstreuungen der in die grabenförmigen Struktur eingebrachten Dotierstoffprofile reduzieren.

In einer Weiterbildung des Verfahrens ist es vorteilhaft, den Bereich der zweiten Wanne in Richtung der Source auszudehnen und die grabenförmige Struktur teilweise oder vollständig innerhalb des Bereichs der zweiten Wanne zu erzeugen. Je weiter die zweite Wanne sich in Richtung der Source ausdehnt, desto stärker erniedrigt sich der spezifische Einschaltwiderstand Rsp, da der Bodenbereich der grabenförmigen Struktur und die zweite Wanne die gleiche Polarität der Dotierung aufweisen. Gleichzeitig weist der Transistor eine hohe Durchbruchspannung auf, da die Konzentration der Dotierungen der ersten und der zweiten Wanne wesentlich geringer sind, als die Konzentration der Source und Drain Bereiche. Ferner lassen beide Wannen in einem einzigen Maskenschritt selbstjustiert durch eine LOCOS-Oxidation herstellen. Dabei ist es vorteilhaft, die erste Wanne tiefer und länger einzutreiben, um unterhalb der grabenförmigen Struktur mittels eines lateralen PN-Übergangs einen RESURF Effekt zur erzeugen, der die Durchbruchspannung erhöht.

In einer anderen Weiterbildung des Verfahrens wird unterhalb des Bereichs der Drain-Dotierung ein Extension Bereich erzeugt, der den Drain Bereich vollständig einschließt, wobei die Dotierung des Extension Bereichs vom gleichen Leitfähigkeitstyps ist, jedoch eine geringere Konzentration wie der Drain Bereich aufweist. Außer der Unterdrückung eines drainseitigen Durchbruchs wird durch die Verringerung des Widerstands im Bereich der drainseitigen Seitenwand der spezifische Einschaltwiderstand Rsp reduziert. Besonders stark reduziert wird der spezifische Einschaltwiderstand Rsp, wenn der Extension Bereich und oder der Drain Bereich unmittelbar an der drainseitigen Seitenwand der grabenförmigen Struktur anschließen.

Untersuchungen der Anmelderin haben gezeigt, daß sich im Bereich des Durchbruchs des Transistors durch einen Abstand zwischen der drainseitigen Seitenwand der grabenförmigen Struktur und dem Extension Bereich und / oder dem Drain Bereich, der vorzugsweise zwischen 0.5 µm und 4.0 µm liegt, eine Symmetrisierung erzielen läßt. Hierbei wird mittels des zusätzlichen drainseitigen Widerstand durch den auftretenden Spannungsabfall eine lokale Überhöhung der Stromdichte unterdrückt. Insbesondere in Verbindung mit einem Querregler lassen sich mit derartigen Transistoren vorteilhafte ESD-Schutzstrukturen herstellen.

In einer Weiterbildung des Verfahrens wird in den Seitenwänden und im Bodenbereich der grabenförmigen Struktur eine höhere Dotierstoffkonzentration als im ersten Wannen Bereich erzeugt, um einerseits mittels eines erhöhten RESURF Effekts die maximale mögliche Sperrspannung zu erhöhen, als auch anderseits den spezifischen Einschaltwiderstand Rsp zu reduzieren.

In einer anderen Weiterbildung des Verfahrens wird in der sourceseitigen Seitenwand und in der drainseitigen Seitenwand der grabenförmigen Struktur die gleiche Dotierstoffkonzentration erzeugt. Dies vereinfacht die Einbringung des Dotierstoffs und erhöht den spezifischen Einschaltwiderstand Rsp nur gering, da sich die einzelnen Konzentrationen der Dotierstoffe summieren, sofern der Extension Bereich und der Drain Bereich unmittelbar an der Seitenwand der grabenförmigen Struktur beginnt und die Eindringtiefe der drainseitigen Dotierung im Bereich der Tiefe der grabenförmigen Struktur liegt. Ferner ist es insbesondere bei tiefen grabenförmigen Strukturen vorteilhaft in der drainseitigen Seitenwand eine höhere Konzentration des Dotierstoffs als in der sourceseitigen Seitenwand zu erzeugen, um einen geringen Einschaltwiderstand Rsp zu erzielen.

Untersuchungen der Anmelderin für unterschiedliche Dotierstoffkonzentration für Wand und Boden haben gezeigt, daß es vorteilhaft ist, wenn das Aspekt Verhältnis der grabenförmigen Struktur oberhalb 0.5 liegt und eine grabenförmige Struktur mit einer Breite in einem Bereich zwischen 0.5 µm und 4.0 µm aufweist. Um Feldstärkeüberhöhungen an Kanten der grabenförmigen Struktur zu unterdrücken, ist es vorteilhaft, geneigte Seitenwände zu erzeugen, d.h. im Bodenbereich weist hiernach die grabenförmige Struktur eine geringere Breite als an der Oberfläche auf. Die Erzeugung der grabenförmigen Struktur lässt sich dabei mit einem Trokkenätzprozeß, wie beispielsweise einem "shallow trench prozeß" (STI), durchführen und mit einem isolierenden Material, wie beispielsweise mittels eines CVD-Oxides oder Nitrides, auffüllen und durch Einsatz eines CMP-Verfahrens planarisieren.

In einer anderen Weiterbildung des Verfahrens wird die grabenförmige Struktur mittels einer V-Grabenätzung erzeugt und in einer nachfolgenden LOCOS-Oxidation, das wegen der geringeren Temperaturbelastung vorzugsweise durch eine Hochdruckoxidation hergestellt wird, aufgefüllt. Die Dotierung der Seitenwände und des Bodens wird vor der LOCOS-Oxidation durchgeführt, wobei die eingebrachte Dosis der Dotierstoffe um den Anteil, der bei der Oxidation in das Oxid eindiffundiert, erhöht wird.

In einer Weiterbildung des Verfahrens wird der DMOS Transistor in der Oberflächenschicht eines Wafer mit einer isolierenden Zwischenschicht erzeugt. Es ist dabei vorteilhaft, wenn die Dicke der unterhalb der grabenförmigen Struktur verbleibenden Oberflächenschicht zwischen der Hälfte und einem Faktor 5 der Tiefe der grabenförmigen Struktur liegt. Ferner ist es vorteilhaft, wenn der Drain Bereich und oder der Extension Bereich, die beiden Wannen Bereiche und der Source Bereich unmittelbar an die isolierende Zwischenschicht anschließen, um die parasitären Kapazitäten zu unterdrücken. Ein weiterer Vorteil ist, daß die erforderliche Schichtdicke der Oberflächenschicht im Bereich von wenigen µm liegt, da die Ausbildung eines hochdotierten vergrabenen Kanals im Anschluß an den Boden der grabenförmigen Struktur, eine geringe vertikale Ausdehnung aufweist.

Untersuchungen der Anmelderin haben gezeigt, daß die nach dem erfindungsgemäßen Verfahren hergestellten DMOS-Transistoren, insbesondere bei Verwendung eines Silizium-Wafers mit einer isolierenden Zwischenschicht, sich besonders zur Herstellung von hochsperrenden integrierten Schaltungen, die einen Ausgangstreiber zum Ansteuern von induktiven Lasten aufweisen, eignen.

Das erfindungsgemäße Verfahren soll nachfolgend anhand von Ausführungsbeispielen im Zusammenhang mit mehreren schematisierten Zeichnungen erläutert werden. Es zeigen die
- Fig. 1: einen Querschnitt eines DMOS Transistors mit einer grabenförmigen Struktur im Driftgebiet, und
- Fig. 2a: ein Querschnitt der Dotierungsschichten des DMOS Transistors zwischen Gate- und Drainbereich, und
- Fig. 2b: ein Potentialverlauf des DMOS Transistors aus der Figur 2a bei einer anliegenden Sperrspannung.

In Tabelle 1 ist eine Prozessfolge zur Herstellung von DMOS-Transistoren dargestellt, in der basierend auf einen nach dem bisherigen Stand der Technik bekannten BCDMOS-Prozeßablauf, zusätzlich die Prozeßschritte 4 bis 8 eingefügt werden. Damit wird zwischen dem Source und Drain Bereich von N- bzw. P-DMOS-Transistoren eine grabenförmige Struktur mit einer frei wählbaren Dotierung in der jeweiligen Seitenwand und einer davon unabhängig wählbaren Dotierung in dem Bodenbereich erzeugt. Mit derartigen Prozessfolgen lassen sich gleichzeitig N- und P-DMOS-Transistoren, bipolare und komplementäre MOS-Transistoren für eine integrierte Schaltung herstellen.

**Tabelle 1:**

| Standart DMOS Modul: | |
|---|---|
| 1. | Material Start: Silizium-Wafer mit einer isolierenden Zwischenschicht |
| 2. | Bildung der P-well (Maskenschritt) |
| 3. | Bildung der N-well (selbstjustiert zur P-well) |
| 4. | BILDUNG DER ÖFFNUNG FÜR EINE GRABENFÖRMIGE STRUKTUR (MASKENSCHRITT) |
| 5. | TILT-IMPLANTATION (FÜR SEITENWAND) |
| 6. | BILDUNG GRABENFÖRMIGER STRUKTUR MITTELS ANISOTROPE SILIZIUMÄTZUNG (STI-PROZESS) (MASKENSCHRITT) |
| 7. | BILDUNG EINER SCHUTZSCHICHT DURCH OXIDATION / DIFFUSION DER EINGEBRACHTEN DOTIERUNG |
| 8. | IMPLANTATION SENKRECHT UND TILT (FÜR BODEN UND DRAINSEITIGER SEITENWAND) (MASKENSCHRITT) |
| 9. | Bildung von Bauelementboxen mittels eines Deep-Trench Prozeß (Maskenschritt) |
| 10. | Füllen der Trenchöffnungen bzw. der grabenförmigen Struktur mit CVD-OXID |
| 11. | CMP-Planarisierung |
| 12. | Extension-Implantation (Maskenschritt) |
| 13. | Schwellspannungs-Implantation |
| 14. | Gateoxidation |
| 15. | Gate-Polyabscheidung und Strukturierung (Maskenschritt) |
| 16. | LDD Implantationen (Maskenschritt) |
| 17. | Source/Drain Implantationen (Maskenschritt) |
| 18. | BPSG- Abscheidung |
| 19. | Ätzung der Kontaktfenster (Maskenschritt) |
| 20. | Metall1 (Maskenschritt) |
| 21. | Via-Ätzung (Maskenschritt) |
| 22. | Metall2 (Maskenschritt) |

Ausgangspunkt für die Herstellung eines DMOS Transistors nach der dargestellten Prozessfolge ist ein Silizium-Wafer mit einer isolierenden Zwischenschicht (SOI-Wafer). Nach der Definition der Wannen wird mittels eines Maskenschrittes 4 eine Öffnung definiert durch die in einem nachfolgenden Schritt 5 die Dotierung für die Seitenwände der zu erzeugenden Struktur implantiert wird. In dem nachfolgenden Schritt 6 wird mittels einer Siliziumätzung eine grabenförmige Struktur erzeugt und anschließend in einem nachfolgenden Schritt 7 die Seitenwände mit einer Schutzschicht belegt. In einem nachfolgenden Schritt 8 wird eine zweistufige Implantation zur Dotierung des Boden und der drainseitigen Seitenwand durchgeführt. Da die Prozeßschritte 4 bis 8 mit einer einzigen Maske durchgeführt werden, sind die eingebrachten Implantationen selbstjustiert. Das Füllen der grabenförmigen Struktur wird gemeinsam mit dem Füllen der Trenchstrukturen durchgeführt. In weiteren Prozeßschritten werden dann die Gate Bereiche und die Source und Drain Bereiche definiert und mittels eines Kontaktfensterprozesses an das Leiterbahnensystem angeschlossen. Durch die Verwendung eines SOI-Wafer mit einer Trenchisolierung liegen die hergestellten Transistoren in einzelnen voneinander isolierten Bauelementboxen.

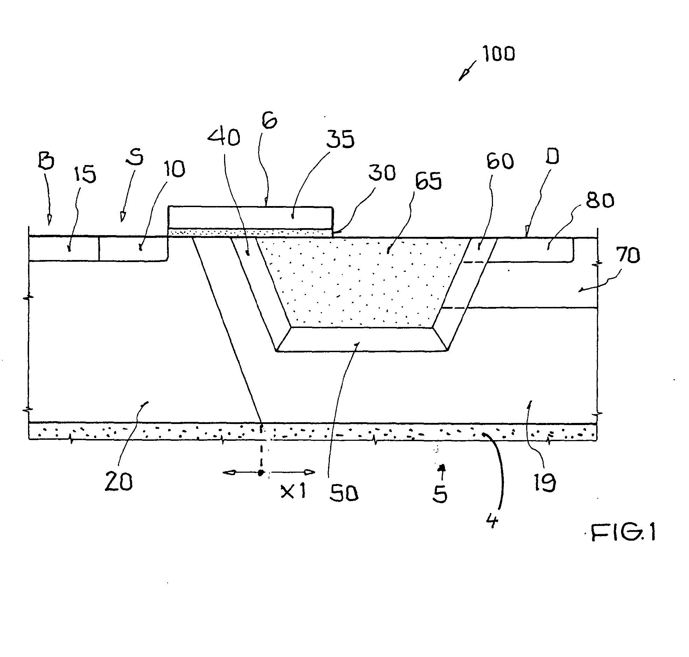

Im Folgenden wird die Abbildung Figur 1 erläutert, in der ein schematisierter Querschnitt eines N-DMOS Transistors 100 mit einer grabenförmigen Struktur dargestellt ist. Die Herstellung des N-DMOS-Transistors 100 wird mittels einer Prozessfolge (nicht abgebildet) innerhalb eines Halbleiterkörpers 5 durchgeführt, der eine isolierende Zwischenschicht 4 aufweist. Hierzu wird in einem ersten Prozeßschritt in dem Halbleiterkörper 5 ein P-Wannen Bereich 20 und ein N-Wannen Bereich 19 selbsjusttiert beispielsweise mittels einer LOCOS Oxidation hergestellt. Die Lage des von den beiden Wannen gebildeten PN-Übergangs läßt sich entlang einer Linie X1 verschieben, indem die Lage und Größe des P-Wannen Maskenbereiches geändert wird. In einem nachfolgenden Prozessschritt wird in einer Schutzschicht, die beispielsweise aus einem Nitrid und oder einem Oxid besteht, durch einen Maskenschritt eine Öffnung für eine Einbringung eines Dotierstoffes mit negativer Polarität, wie beispielsweise Arsen oder Phosphor, erzeugt. Um die drainseitige Konzentration des Dotierstoffes zu erhöhen, wird die Implantation unter einem Tiltwinkel von beispielsweise 60 Grad implantiert. In einem nachfolgenden Prozessschritt wird mittels einer anisotropen Siliziumatzung, beispielsweise mittels einer STI-Ätzung, eine grabenförmige Struktur erzeugt und der Dotierstoff im Bodenbereich vollständig entfernt. In einem nachfolgenden Prozessschritt wird ein Streuoxid erzeugt, dessen Dicke ausreichend ist, um den Dotierstoffeintrag durch eine zweite Implantation in dem Bodenbereich der grabenförmigen Struktur wirksam zu unterdrücken. Da die Seitenwände nur leicht geneigt sind, genügen hierzu Oxiddicken im Bereich von wenigen 100 A. Durch den Oxidationsschritt wird gleichzeitig der aus dem ersten Implantationsschritt verbleibende Dotierstoff eindiffundiert, wobei sich sourceseitig ein erster Bereich 40, mit einer ersten Konzentration und drainseitig ein zweiter Bereich 60, mit einer zweiten Konzentration, ausbildet. In einem nachfolgenden Prozeßschritt wird in einem zweiten Implantationsschritt der zweistufig durchgeführt wird, ein Dotierstoff mit einer negativen Polarität eingebracht. Hierbei wird in der ersten Stufe ein Teil der Gesamtdosis senkrecht, d.h. nur in einen Bodenbereich 50 eingebracht und in der zweiten Stufe die verbleibende Dosis unter einem Tilt-Winkel von beispielsweise 60 Grad eingebracht, so daß die Konzentration in dem drainseitigen Bereich des Bodens 50 und in der drainseitigen Seitenwand 60 weiter erhöht wird. Nach beiden Implantationsschritten weist in Summe der Bereich 60 eine hohe Konzentration, der Bereich 50 eine mittlere Konzentration und der Bereich 40 eine niedrigere Konzentration eines Dotierstoffes von der negativen Polarität auf. In einem nachfolgenden Prozessschritt wird die grabenförmige Struktur mit einem isolierenden Material, beispielsweise mit einem CVD-Oxid 65, aufgefüllt und die Oberfläche der grabenförmigen Struktur durch einen CMP-Schritt planarisiert. In mehreren nachfolgenden Prozessschritten, die in bekannten MOS-Prozeßarchitekturen immanent sind, wird ein Gateanschluß G mit einem Gateoxid 30 und einer Polisiliziumschicht 35 erzeugt. Ferner wird in nachfolgenden ebenfalls bekannten Prozessschritten ein Sourceanschluß S mit einem hochdotierten Bereich 10 und ein Drainanschluß D mit einem hochdotierten Bereich 80, die eine negative Polarität aufweisen, sowie ein Bodyanschluß B mit einem hochdotierten Bereich 15, der eine positive Polarität aufweist, erzeugt. Ferner wird unterhalb des Drainsanschlusses D ein Extension Bereich 70 mit einer negativen Polarität erzeugt, dessen Konzentration geringer als die des Bereichs 80 ist. Ferner schließt sich der Extension Bereich 70 und der Drain Bereich 80 unmittelbar an die drainseitige Seitenwand der grabenförmigen Struktur an, so daß sich die Konzentrationen der Bereiche 60, 70, 80 entlang der Seitenwand summieren. Des Weiteren wird der Bereich des Sourceanschlusses 10 von dem P-Wannen Bereich 20 eingeschlossen, wobei in lateraler Richtung die P-Wanne unmittelbar an die N-Wanne anschließt. Ferner grenzt der P-Wannen Bereich 20 und der N-Wannen Bereich 19 unmittelbar an die isolierende Zwischenschicht 4 an.

Besonders vorteilhaft an der dargestellten Prozeßfolge ist, daß sich damit sowohl N-DMOS als auch P-DMOS Transistoren gemeinsam herstellen lassen, wobei durch die Herstellung der grabenförmigen Struktur mittels einer Trockenätzung die Temperaturbelastung im Herstellungsprozeß erheblich reduziert wird. Hiermit lassen sich entlang der grabenförmigen Struktur steile, räumlich begrenzte, unterschiedlich hochdotierte Bereiche erzeugen, mit denen sich die elektrischen Parameter des DMOS Transistors leicht optimieren lassen. Insbesondere lassen sich mit den niedrigen spezifischen Einschaltwiderständen Rsp und den gleichzeitig hohen Sperrspannungen große Stromtragfähigkeiten auf kleiner Fläche erzielen, da sich unter anderem der Spannungsabfall im Driftgebiet des Transistors verringert. Ferner lassen sich durch Einfügen von Epitaxieschichten und / oder buried layer Schichten die DMOS Transistoren mit wenig zusätzlichen Prozessschritten einfach gegeneinander isolieren. Ferner wird durch die Ausbildung der N-Wanne im Bereich des Drift-Bereichs des Transistors der Sättigungsstrom Idsat erhöht. Des Weiteren wird erhöht sich die Sperrspannung, da der N-Wannen Bereich 19 im Vergleich zum Extension Bereich 70 eine geringere Konzentration des Dotierstoffs aufweist.

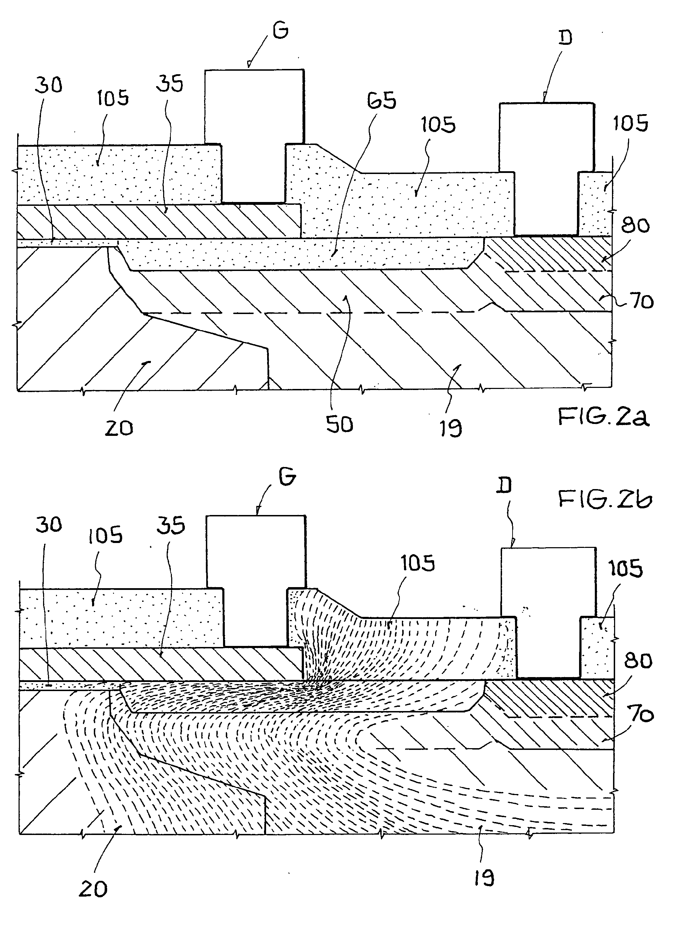

In Figur 2a ist im Querschnitt die Dotierungsschichten des Teils zwischen Gate Bereich 35 und Drain Bereich 80 des N-DMOS Transistors 100 aus der Figur 1 dargestellt. Der N-DMOS 100 wird mit einer Prozeßfolge, wie sie in Zusammenhang mit den Zeichnungsunterlagen zu der Figur 1 erläutert wurde, hergestellt, wobei in Erweiterung auf der Oberfläche der Halbleiterstruktur eine passivierende Schicht aus Oxid 105 aufgebracht ist. Ferner weist die Schicht 105 sowohl eine Öffnung für den Gatenschluß G als auch eine Öffnung für den Drainanschluß D auf, die mit einem Metall aufgefüllt sind. Des Weiteren ist in den Bereichen 19, 20, 35, 50, 70 und 80 die Polarität des Dotierstoffs durch die Richtung einer Schraffur dargestellt. Hierbei sind diejenigen Bereiche, die eine negative Polarität aufweisen, mit Strichen von links oben nach rechts unten schraffiert und diejenigen Bereich die eine positive Polarität aufweisen, mit Strichen von rechts oben nach links unten schraffiert. Ferner wird die Höhe der Konzentration des Dotierstoff in dem jeweiligen Bereich durch die Dichte der Schraffur wiedergegeben. Ferner schließt der Bereich der N-Wanne 19 den Extension Bereich 70 ein, wobei der Bereich der N-Wanne 19 und der Bereich der P-Wanne 20 eine vergleichbare Konzentration des Dotierstoffs aufweisen. Ferner wird unterhalb der grabenförmigen Struktur zwischen dem P-Wannen Bereich 20 und dem N-Wannen Bereich 19 ein PN-Übergang erzeugt, der eine laterale Komponente aufweist. Hierzu wird die P-Wanne beispielsweise vor der N-Wanne hergestellt.

In Figur 2b wird der Potentialverlauf des in Figur 2a abgebildeten Transistors bei einer anliegenden Sperrspannung kurz vor dem Durchbruch des Transistors dargestellt. Hierbei gibt die Schar der einzelnen Potentiallinien den Potential Verlauf zwischen dem Kanalbereich unterhalb des Gateoxides 30 und dem Bereich der Drain 70, 80 wieder, wobei der Ort der größten Feldstärke durch den Ort mit der höchsten Dichte an Potentiallinien wiedergegeben wird. Hierbei zeigt sich, der Transistor im Driftgebiet eine gleichmäßige Verteilung der Potentiallinien aufweist, wobei insbesondere durch die laterale Ausbildung des PN-Übergangs unterhalb der grabenförmigen Struktur zwischen der beiden Wannen der RESURF Effekt verstärkt wird. Insbesondere wird der Bereich der sourceseitigen Seitenwand in der grabenförmigen Struktur durch die Ausbildung einer Raumladungszone bevorzugt ausgeräumt, sodaß der RESURF Effekt bereits bei kleinen Spannungen einsetzt und Feldstärkespitzen vermieden werden. Durch die gleichmäßige Verteilung der Potentiallinien im Driftgebiet werden hohe Sperrspannungen erreicht, dessen Höhe sich im Wesentlichen aus den Konzentrationen der Dotierstoffe in den Wannen Bereichen 19 bzw 20 bestimmt. Ferner wird durch die hohe Konzentration des Dotierstoffes insbesondere im drainseitigen Bereich der grabenförmigen Struktur in Verbindung mit der N-Wanne die Stromtragfähigkeit Idsat des DMOS-Transistors erhöht und den spezifischen Einschaltwiderstand verringert. Hiermit wird der Flächenverbrauch insbesondere für Treiberanwendungen bei hohen Strömen erniedrigt.

Ein weiterer Vorteil besteht in der einfachen Übertragbarkeit des neuen Verfahrens auf Wafer, die eine isolierende Zwischenschicht aufweisen, wie beispielsweise SOI-Wafer. Die vertikal räumlich begrenzten hochdotierten Gebiete unterhalb der grabenförmigen Struktur reduzieren die Dicke der Oberflächenschicht, wobei durch die Ausbildung eines lateralen PN-Übergangs unterhalb der grabenförmigen Struktur hohe Sperrspannungen auch im angeschalteten Zustand erreicht werden. Ferner wird durch die unterliegende isolierende Zwischenschicht, die im Allgemeinen eine höhere Dielektrizitätskonstante als Silizium aufweist, durch eine immanente Bündelung der Potentiallinien der RESURF Effekt verstärkt und mittels der geringen Feldstärke im Driftgebiet die Sperrspannungen zwischen Drain und Source erhöht. Insbesondere läßt sich die Schichtdicke, der auf der isolierenden Zwischenschicht aufliegenden Oberflächenschicht, gering halten und weitere Arten von Bauelementen, wie beispielsweise bipolare und MOS-Transistoren mit wenigen zusätzlichen Prozessschritten kostengünstig gemeinsam mit den DMOS Transistoren auf einem Wafer integrieren. Ferner lassen sich insbesondere durch die geringe Dicke der Oberflächenschicht die parasitären Kapazitäten unterdrücken, indem ein Teil der Dotierungsbereiche, wie beispielsweise die P-Wanne, die N-Wanne und der Extension Bereich, bis an die isolierende Zwischenschicht ausgedehnt werden.

## Patentansprüche

1. Verfahren zur Herstellung eines DMOS-Transistors (100) mit einem Halbleiterkörper (5),
• der eine Oberflächenschicht mit einem Source Bereich (10) und einem Drain Bereich (80) eines zweiten Leitfähigkeitstyps und einen ersten den Source Bereich (10) umschließenden Wannen Bereich (20) eines ersten Leitfähigkeitstyps und einen zweiten den Drain Bereich umschließenden Wannen Bereich (19) eines zweiten Leitfähigkeitstyps aufweist, und
• auf der Oberfläche der Oberflächenschicht des Halbleiterkörpers (5) ein Gate Bereich (35) ausgebildet ist, der sich beginnend von dem Source Bereich (10) vollständig über den ersten Wannen Bereich (20) erstreckt,
**dadurch gekennzeichnet, daß**
• ausgehend von der Oberfläche des Halbleiterkörpers (5) in der Oberflächenschicht eine grabenförmige Struktur erzeugt wird, und
• im Bodenbereich (50) der grabenförmigen Struktur eine Dotierung des zweiten Leitfähigkeitstyps mit einer ersten Konzentrationswert erzeugt wird, und
• in der sourceseitigen Seitenwand (40) der grabenförmigen Struktur eine Dotierung des zweiten Leitfähigkeitstyps mit einer zweiten Konzentrationswert erzeugt wird, und
• in der drainseitigen Seitenwand (60) der grabenförmigen Struktur eine Dotierung des zweiten Leitfähigkeitstyps mit einer dritten Konzentrationswert erzeugt wird.

2. Verfahren nach Anspruch 1, **dadurch gekennzeichnet, daß** die grabenförmige Struktur teilweise oder vollständig innerhalb des zweiten Wannen Bereichs (19) erzeugt wird.

3. Verfahren nach Anspruch 1 oder 2, **dadurch gekennzeichnet, daß** unterhalb des Drain Bereichs (80) ein Extension Bereich (70) eines zweiten Leitfähigkeitstyps erzeugt wird, der den Drain Bereich (80) umschließt.

4. Verfahren nach einem der Ansprüche 1 bis 3, **dadurch gekennzeichnet, daß** der Drain Bereich (80) unmittelbar angrenzend an einer Seitenwand der grabenförmigen Struktur erzeugt wird.

5. Verfahren nach Anspruch 3, **dadurch gekennzeichnet, daß** der Extension Bereich (70) unmittelbar angrenzend an einer Seitenwand der grabenförmigen Struktur erzeugt wird.

6. Verfahren nach Anspruch 3, **dadurch gekennzeichnet, daß** ein Abstand zwischen der Seitenwand der grabenförmigen Struktur und dem Extension Bereich (70) erzeugt wird, der vorzugsweise zwischen 0.5 µm und 4.0 µm liegt.

7. Verfahren nach einem der Ansprüche 1 bis 3, **dadurch gekennzeichnet, daß** ein Abstand zwischen der Seitenwand der grabenförmigen Struktur und dem Drain Bereich (80) erzeugt wird, der vorzugsweise zwischen 0.5 µm und 4.0 µm liegt.

8. Verfahren nach einem der Ansprüche 1 bis 7, **dadurch gekennzeichnet, daß** in den Seitenwänden und im Bodenbereich (50) der grabenförmigen Struktur eine Dotierung auf einem höheren Konzentrationswert als im ersten Wannen Bereich (20) erzeugt wird.

9. Verfahren nach einem der Ansprüche 1 bis 8, **dadurch gekennzeichnet, daß** eine grabenförmige Struktur erzeugt wird, in der zweite Wert und der dritte Wert der Konzentration gleich sind.

10. Verfahren nach einem der Ansprüche 1 bis 8, **dadurch gekennzeichnet, daß** eine grabenförmige Struktur erzeugt wird, in der zweite Wert der Konzentration kleiner als der dritte Wert der Konzentration des Dotierstoffes ist.

11. Verfahren nach einem der Ansprüche 1 bis 10, **dadurch gekennzeichnet, daß** eine grabenförmige Struktur erzeugt wird, deren Aspekt Verhältnis oberhalb 0.5 und deren Breite in einem Bereich zwischen 0.5 µm und 4.0 µm liegt.

12. Verfahren nach einem der Ansprüche 1 bis 11, **dadurch gekennzeichnet, daß** eine grabenförmige Struktur erzeugt wird, die im Bodenbereich (50) eine geringere Breite als an der Oberfläche aufweist.

13. Verfahren nach einem der Ansprüche 1 bis 12, **dadurch gekennzeichnet, daß** die grabenförmige Struktur mittels einer STI Ätzung erzeugt und mit einem isolierenden Material, vorzugsweise mittels eines Oxids, aufgefüllt wird.

14. Verfahren nach einem der Ansprüche 1 bis 13, **dadurch gekennzeichnet, daß** die grabenförmige Struktur mittels einer LOCOS-Oxidation erzeugt wird.

15. Verfahren nach einem der Ansprüche 1 bis 14, **dadurch gekennzeichnet, daß** der Halbleiterkörper unterhalb der Oberflächenschicht eine isolierende Zwischenschicht (4) aufweist und der DMOS Transistor in der Oberflächenschicht erzeugt wird.

16. Verfahren nach Anspruch 15, **dadurch gekennzeichnet, daß** die Dicke der Oberflächenschicht unterhalb der grabenförmigen Struktur in einem Bereich zwischen der Hälfte und einem Faktor 5 der Tiefe der grabenförmigen Struktur liegt.

17. Verfahren nach Anspruch 15 oder 16, **dadurch gekennzeichnet, daß** der Drain Bereich (80) und oder der Extension Bereich (70), sowie die beiden Wannen Bereiche (19, 20) und der Source Bereich (10) unmittelbar angrenzend an die isolierende Zwischenschicht (4) erzeugt wird.

18. Verwendung des Verfahrens nach einem der Ansprüche 1 bis 17 zur Herstellung einer integrierten Schaltung.
